# FASCICULE DE BREVET EUROPEEN

(11) **EP 0 368 390 B1**
(45) Date de publication et mention de la délivrance du brevet: **13.07.1994**
(21) Numéro de dépôt: 89202739.2
(22) Date de dépôt: 30.10.1989
(51) Int. Cl.: H04N 7/10, H04N 5/44, H04N 7/08, H04J 1/00, H05K 7/00

(54) **Système d'amplification pour télédistribution**
Verstärkungssystem für Fernverteilung
Amplification system for teledistribution

(30) Priorité: 04.11.1988 FR 8814424
(43) Date de publication de la demande: 16.05.1990
(73) Titulaire: PHILIPS ELECTRONIQUE GRAND PUBLIC, 92150 Suresnes (FR); Philips Electronics N.V., 5621 BA Eindhoven (NL)
(72) Inventeur: Chanteau, Pierre Société Civile S.P.I.D., F-75008 Paris (FR)
(74) Mandataire: Charpail, François

(56) Documents cités:
- DE-B- 1 143 547
- DE-B- 1 263 886
- GB-A- 2 173 077
- BRÜCKE ZUM KUNDEN, no. 71, 1973, pages 3-5; "Neue UKW-Kanalumsetzer übertragen viele Programme in bester Stereo-Qualität für grosse Gemeinschafts-Antennenanlagen"

## Description

La présente invention a pour objet un système d'amplification pour télédistribution constitué de façon modulaire avec des modules de télévision assemblés sur un module de base comportant une alimentation, chacun des modules de télévision comportant au moins une première face équipée d'un connecteur pour un signal de télévision et une deuxième face, parallèle à la première, équipée d'un connecteur pour un signal de télévision, lesquels connecteurs sont situés de telle sorte que les modules de télévision s'emboîtent directement entre eux pour former une rangée, le module de base étant lui même équipé d'un connecteur pour recevoir une rangée de modules de télévision.

De tels systèmes sont utilisés pour la réception collective des signaux de télévision ou de radio émis à partir d'émetteurs soit terrestres soit satellisés ; la distribution s'effectue par exemple dans un immeuble.

Un tel système est connu de DE-A-1 263 886. Selon ce document, une batterie d'amplificateurs sont mis en parallèle sur une ligne de sortie commune, avec une alimentation commune. Or selon les sites d'implantation les antennes de réception sont orientées différemment et les canaux reçus ne sont pas les mêmes ce qui nécessite, de la part des installateurs, de multiples choix d'appareils et de connexions ainsi que des filtrages devant porter sélectivement sur certains canaux. Certains choix d'appareils et certains réglages ne sont pas possibles avec un système comme celui du document cité : par exemple le système connu ne permet pas d'intercaler un module pour modifier par filtrage une partie du signal sans modifier tout ce qui lui arrive de l'amont ou sans incorporer des éléments supplémentaires relativement coûteux et/ou volumineux, comme des coupleurs directifs, dans le module.

La présente invention a pour but de procurer une plus grande souplesse dans le choix des fonctions possibles, en permettant à l'installateur de réaliser une grande variété d'installations différentes à partir d'un nombre limité de modules fonctionnels.

A cet effet, selon la présente invention, un système pour télédistribution est particulièrement remarquable en ce que, les susdits connecteurs étant appelés premiers connecteurs, chacun des dits modules de télévision réalisant une des fonctions parmi au moins les fonctions de filtrage sélectif, d'amplification, et de conversion de fréquence, pour des signaux UHF reçus soit d'une antenne soit d'un autre module, chacun d'eux comporte sur chacune des deux dites faces parallèles un second connecteur pour un signal de télévision disposé de telle façon qu'il permet, comme le premier, de connecter entre eux deux modules d'une rangée, un module de filtrage sélectif comporte à l'intérieur du module, d'une part une ligne 75 ohm d'entrée UHF reliant entre eux les deux premiers connecteurs et d'autre part une ligne 75 ohm de sortie UHF reliant entre eux les deux seconds connecteurs avec couplage sélectif entre ces deux lignes, dans un module d'amplification ou de conversion de fréquence le premier connecteur qui est porté par la face prévue pour être tournée vers le module de base constitue une sortie de signal UHF et le premier connecteur qui est porté par la face prévue pour tourner le dos au module de base constitue une entrée de signal UHF qui est chargée par une charge contenue dans le module, le signal à convertir en fréquence ou à amplifier étant entré soit par le second connecteur qui est porté par la face prévue pour tourner le dos au module de base, soit par un troisième connecteur disposé sur une troisième face du module, dans ce cas les deux seconds connecteurs étant reliés entre eux par une ligne 75 ohm, et le module de base comporte d'une part des connecteurs coaxiaux d'arrivée d'antenne VHF, et d'autre part quatre connecteurs coaxiaux, dont deux "premiers" et deux "seconds", lesquels sont positionnés pour permettre la connexion de deux rangées constituées chacune par des modules UHF, et des moyens pour amplifier et ajouter les uns aux autres les signaux présents sur les seconds connecteurs et le signal présent sur les connecteurs d'arrivée d'antenne VHF, et les délivrer sur une sortie. Une telle conception modulaire est souple et économique car, quel que soit le site, la structure générale est la même, et les installateurs ont simplement à choisir, parmi un jeu de modules standardisés, les modules adaptés au site; l'existence d'un jeu de modules standardisés implique clairement des économies de fabrication.

Il est avantageux que chaque dite ligne 75 ohm assure en outre le passage d'une composante continue, superposée aux signaux UHF, pour alimenter les dits modules d'amplification et/ou de conversion de fréquence à partir du circuit d'alimentation situé dans le dit module de base.

Lorsque le système comporte en outre un module amplificateur pour la bande satellite, il est avantageux qu'un tel module satellite et le module de base comportent des moyens de connexion et de couplage entre eux pour délivrer sur au moins une connexion de sortie large bande l'ensemble des signaux, satellite d'une part, et en provenance du dit module de base d'autre part.

Ainsi les signaux à télédistribuer sont tous disponibles sur une même sortie.

Il est même avantageux que le dit module satellite comporte en outre des moyens répartiteurs large bande pour délivrer l'ensemble des dits signaux sur plusieurs connexions de sortie.

Ainsi un début de distribution peut s'effectuer déjà au niveau du système d'amplification.

Le dit module satellite et le dit module de base étant séparément assemblés dans des boîtiers moulés, il est avantageux que le même modèle de boîtier extérieur soit utilisé pour chacun des deux modules, lequel boîtier comporte au moins :
- sur une première face 3 connecteurs pour y connecter, selon le type de module, soit les entrées VHF soit les sorties large bande,
- sur une deuxième face 2 connecteurs, un de type mâle et un de type femelle, pour connecter directement les deux modules entre eux,
- sur une troisième face un connecteur pour recevoir les signaux satellites,
- sur une quatrième face quatre connecteurs pour y connecter les deux rangées de modules UHF.

Ce mode de montage constitue une facilité à la fois mécanique et électrique; en effet les boîtiers étant à la masse, le rail constitue une masse commune pour tous les modules.

Avantageusement le système est assemblé sur un panneau support muni de rails de guidage et chaque module comporte un système de pattes agencées pour être disposées le long des rails et y être maintenues, les modules étant ainsi guidés de telle sorte que les connecteurs coaxiaux à connecter entre eux se présentent de façon correcte vis à vis l'un de l'autre.

Ce mode de montage constitue une facilité à la fois mécanique et électrique; en effet les boîtiers étant à la masse, le rail constitue une masse commune pour tous les modules.

La présente invention sera mieux comprise à l'aide d'un exemple, non limitatif, de réalisation illustrée par les dessins suivants :
La figure 1 représente les éléments principaux d'un système selon l'invention.
La figure 2 représente la connexion et le boîtier du module satellite.

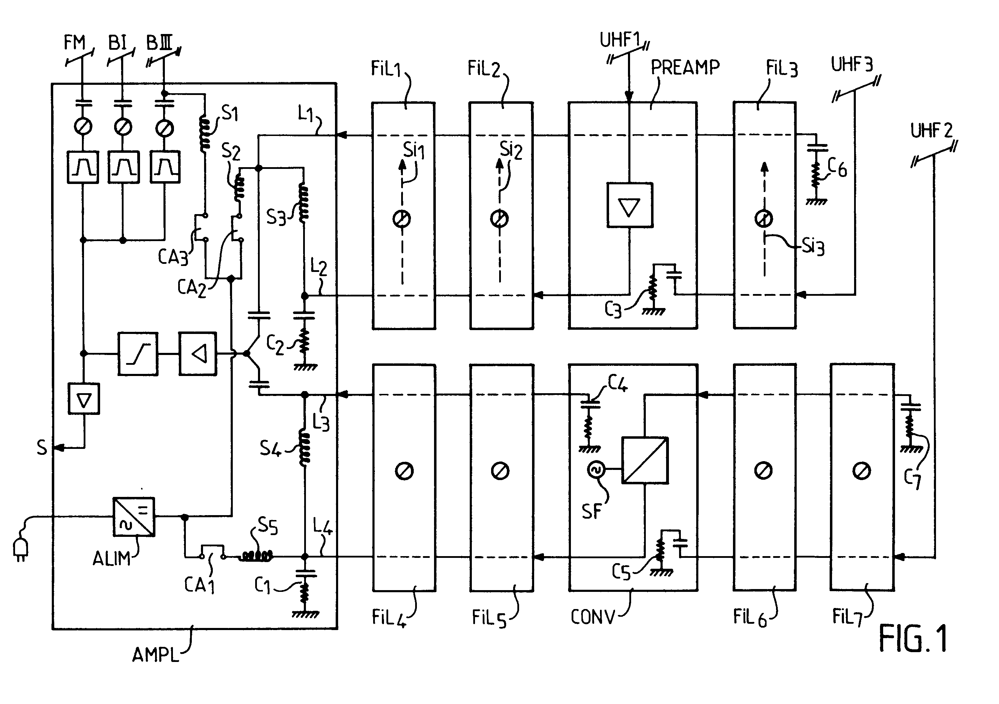

Le système de la figure 1 comporte un module amplificateur principal (AMPL) et des modules UHF disposés sur deux rangées; la première rangée est ici constituée des modules de filtrage FIL1, FIL2, FIL3 et d'un module d'amplification PREAMP; la deuxième rangée est constituée des modules de filtrage FIL4, FIL5, FIL6, FIL7 et d'un module de conversion de fréquence CONV; tous les filtres sont des filtres passe-bande et comportent, de préférence, un atténuateur pour homogénéiser le niveau des signaux.

Le module principal AMPL comporte, sur une face du boîtier, trois connexions pour antennes VHF ici représentées par des antennes FM, BI, BIII; le traitement de ces signaux VHF est connu, et symboliquement représenté, jusqu'à la sortie S.

Le module principal AMPL comporte aussi, sur une autre face du boîtier, quatre connexions pour les lignes L1, L2, L3, L4; la ligne L1 est la ligne d'entrée pour les signaux en provenance des antennes UHF1 et UHF3; les signaux de l'antenne UHF3 sont filtrés dans le filtre FIL3 de telle sorte que le signal prélevé SI3 sort du filtre par la ligne L1; les signaux de l'antenne UHF1 sont préamplifié dans l'ampli PREAMP et en ressortent sur la ligne L2; le filtre FIL2 prélève le signal SI2 et le filtre FIL1 prélève le signal SI1 de telle sorte que à l'entrée L1 les 3 signaux SI1, SI2 et SI3 sont présents; on sait que, en pratique, avec un tel montage en Z, la totalité du signal n'est pas prélevée par le filtre mais ce montage est quand même préférable à des filtres montés en parallèle entre des batteries de répartiteurs.

Les signaux reçus par l'antenne UHF2 sont similairement traités par les filtres FIL4, FIL5 et FIL6, FIL7 et par le module de conversion de fréquence CONV de sorte que les signaux prélevés sont présents sur l'entrée L3.

Ainsi les lignes L1 et L3 constituent des lignes 75 ohm d'entrée UHF, et les lignes L2 et L4 constituent des lignes 75 ohm de sortie UHF, avec couplage sélectif entre les lignes L1 et L2 et entre les lignes L3 et L4.

Il est clair que la configuration représentée est un exemple non limitatif et que des modules pourraient être ajoutés ou enlevés dans chaque rangée en fonction des besoins spécifiques à chaque site.

Ce qui est indispensable pour le bon fonctionnement de ce système modulaire c'est que chaque ligne L1, L2, L3, L4 soit terminée par une charge de 75 ohm; selon le cas, la charge est soit intégrée dans un module : C1, C2, C3, C4, C5, soit constituée par un module de charge ajouté en bout de ligne : C6, C7.

Chaque charge comporte un condensateur car les lignes L1, L2, L3, L4 sont aussi utilisées pour assurer le passage d'une composante continue pour alimenter les modules PREAMP et CONV. Le module principal AMPL comporte une alimentation ALIM qui transmet du courant continu à travers les 3 cavaliers CA1, CA2 et CA3; des selfs sont disposées adéquatement S1, S2, S3, S4, S5, pour bloquer les signaux HF et ainsi l'alimentation est disponible indifféremment sur chacune des lignes L1, L2, L3, L4, et sur l'entrée d'antenne BIII.

Dans ce type de montage, on remarquera que le module de conversion de fréquence CONV comporte un synthétiseur de fréquence (SF) et ne comporte pas de filtre du fait qu'il est systématiquement associé à au moins un module de filtrage en entrée et un en sortie, ces modules de filtrage étant tous du même modèle à la fréquence près; c'est pourquoi un seul modèle de module de conversion de fréquence est suffisant quelque soit le site et se substitue aux divers modèles de convertisseur monocanal et de triplet.

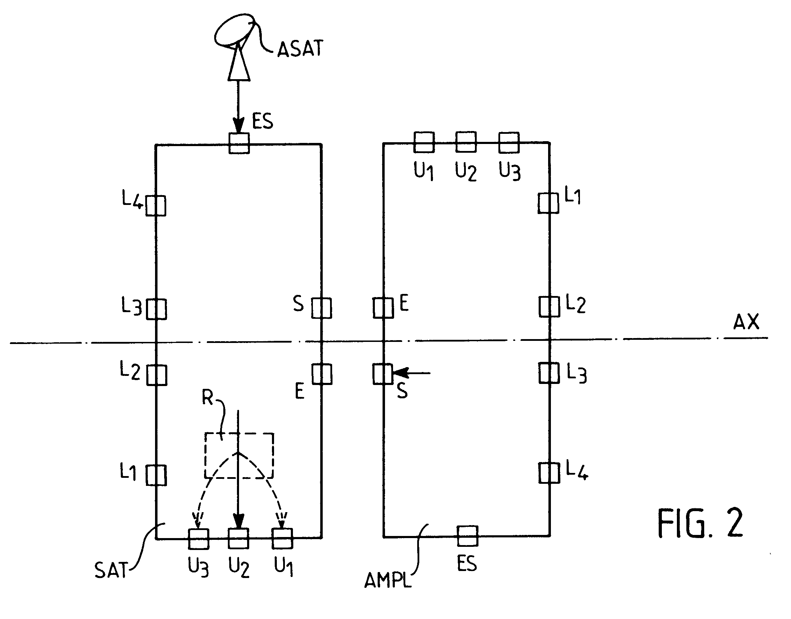

Sur la figure 2 on retrouve le système modulaire de la figure 1 mais seul le module amplificateur principal AMPL est représenté; ce module AMPL est connecté à un module amplificateur pour la bande satellite SAT.

La sortie S du module AMPL est connectée à l'entrée E du module SAT; le module SAT reçoit par son entrée satellite ES les signaux en provenance de l'antenne satellite ASAT lesquels sont traités d'une manière connue.

L'ensemble des signaux qu'ils soient satellite, ou VHF, ou UHF, sont alors délivrés sur la sortie U2 du module SAT; le cas échéant le module SAT peut optionnellement comporter un répartiteur R, représenté en pointillé, pour délivrer les signaux sur 1, 2 ou 3 des trois sorties U1, U2, U3.

Les modules AMPL et SAT ont une dimension mécanique extérieure similaire, c'est pourquoi il est avantageux, pour des raisons économiques, d'utiliser le même boîtier moulé, par exemple en zamac, pour les deux modules; ceci est mis en évidence sur la figure 2 par le fait que les connecteurs portent les mêmes repères; bien entendu les circuits internes ne sont pas les mêmes et les connecteurs sont utiles ou superflus suivant le cas :
- les connecteurs L1, L2, L3, L4 sont utiles dans le module AMPL, et superflus dans le module SAT;
- les connecteurs U1, U2, U3 sont utiles pour la connexion d'entrée VHF dans le module AMPL, et aussi utiles, mais pour les connexions de sortie dans le module SAT;
- le connecteur ES est utile dans le module SAT, et superflu dans le module AMPL
- les connecteurs E du module SAT et S du module AMPL sont utiles, par contre les connecteurs S du module SAT et E du module AMPL sont superflus; toutefois on peut considérer que ces derniers assurent une certaine tenue mécanique du fait qu'ils sont nécessairement male et femelle et donc emboîtés simultanément avec les deux autres qui eux sont utilement connectés.

D'un point de vue mécanique et électrique, il est clair que tous ces modules sont connectés directement entre eux; avantageusement les connecteurs sont intégrés dans les boîtiers extérieurs et ils sortent bruts de moulage lorsque les boîtiers sont constitués de deux coquilles en zamac dont le plan de contact se situe au milieu de chaque connecteur.

Le contact de masse est ainsi très bien assuré entre tous les boîtiers; la structure modulaire décrite est symétrique autour de l'axe AX, cette symétrie permet de monter les modules sur des rails de guidage et de maintien par exemple en forme de mortaise; chaque module étant pourvu de tenons, ou pattes, correspondant à cette mortaise, l'ensemble modulaire peut être ainsi monté sur un panneau de support constitué par les rails; ainsi chaque module est guidé lors du montage dans les rails de telle sorte que les connecteurs coaxiaux se présentent normalement les uns en face des autres.

## Revendications

1. Système d'amplification pour télédistribution constitué de façon modulaire avec des modules de télévision assemblés sur un module de base comportant une alimentation, chacun des modules de télévision comportant au moins une première face équipée d'un connecteur pour un signal de télévision et une deuxième face, parallèle à la première, équipée d'un connecteur pour un signal de télévision, lesquels connecteurs sont situés de telle sorte que les modules de télévision s'emboîtent directement entre eux pour former une rangée, le module de base étant lui même équipé d'un connecteur pour recevoir une rangée de modules de télévision, caractérisé en ce que, les susdits connecteurs étant appelés premiers connecteurs, chacun des dits modules de télévision réalisant une des fonctions parmi au moins les fonctions de filtrage sélectif, d'amplification, et de conversion de fréquence, pour des signaux UHF reçus soit d'une antenne soit d'un autre module, chacun d'eux comporte sur chacune des deux dites faces parallèles un second connecteur pour un signal de télévision disposé de telle façon qu'il permet, comme le premier, de connecter entre eux deux modules d'une rangée, un module de filtrage sélectif comporte à l'intérieur du module, d'une part une ligne 75 ohm d'entrée UHF reliant entre eux les deux premiers connecteurs et d'autre part une ligne 75 ohm de sortie UHF reliant entre eux les deux seconds connecteurs avec couplage sélectif entre ces deux lignes, dans un module d'amplification ou de conversion de fréquence le premier connecteur qui est porté par la face prévue pour être tournée vers le module de base constitue une sortie de signal UHF et le premier connecteur qui est porté par la face prévue pour tourner le dos au module de base constitue une entrée de signal UHF qui est chargée par une charge contenue dans le module, le signal à convertir en fréquence ou à amplifier étant entré soit par le second connecteur qui est porté par la face prévue pour tourner le dos au module de base, soit par un troisième connecteur disposé sur une troisième face du module, dans ce cas les deux seconds connecteurs étant reliés entre eux par une ligne 75 ohm, et le module de base comporte d'une part des connecteurs coaxiaux d'arrivée d'antenne VHF, et d'autre part quatre connecteurs coaxiaux, dont deux "premiers" et deux "seconds", lesquels sont positionnés pour permettre la connexion de deux rangées constituées chacune par des modules UHF, et des moyens pour amplifier et ajouter les uns aux autres les signaux présents sur les seconds connecteurs et le signal présent sur les connecteurs d'arrivée d'antenne VHF, et les délivrer sur une sortie.

2. Système selon la revendication 1 caractérisé en ce que chaque dite ligne 75 ohm assure en outre le passage d'une composante continue, superposée aux signaux UHF, pour alimenter les dits modules d'amplification et/ou de conversion de fréquence à partir du circuit d'alimentation situé dans le dit module de base.

3. Système selon l'une des revendications 1 ou 2, comportant en outre un module amplificateur pour la bande satellite caractérisé en ce que ce module satellite et le module de base comportent des moyens de connexion et de couplage entre eux pour délivrer sur au moins une connexion de sortie large bande l'ensemble des signaux, satellite d'une part, et en provenance du dit module de base d'autre part.

4. Système selon la revendication 3 caractérisé en ce que le dit module satellite comporte en outre des moyens répartiteur large bande pour délivrer l'ensemble des dits signaux sur plusieurs connexions de sortie.

5. Système selon l'une des revendications 3 ou 4, le dit module satellite et le dit module de base étant séparément assemblés dans des boîtiers moulés, caractérisé en ce que le même modèle de boîtier extérieur est utilisé pour chacun des deux modules, lequel boîtier comporte au moins :
- sur une première face 3 connecteurs pour y connecter, selon le type de module, soit les entrées VHF soit les sorties large bande
- sur une deuxième face 2 connecteurs, un de type mâle et un de type femelle, pour connecter directement les deux modules entre eux
- sur une troisième face un connecteur pour recevoir les signaux satellites
- sur une quatrième face quatre connecteurs pour y connecter les deux rangées de modules UHF.

6. Système selon l'une quelconque des revendications précédentes caractérisé en ce qu'il est assemblé sur un panneau support muni de rails de guidage et en ce que chaque module comporte un système de pattes agencées pour être disposées le long des rails et y être maintenues, les modules étant ainsi guidés de telle sorte que les connecteurs coaxiaux à connecter entre eux se présentent de façon correcte vis à vis l'un de l'autre.

## Claims

1. An amplification system for teledistribution, constituted in a modular way by television modules assembled on a principal module comprising a power supply, each television module having at least a first face provided with a connector for a television signal and a second face parallel to the first, provided with a connector for a television signal, which connectors are situated in such a way that the television modules directly fit into each other for forming a row, the principal module being provided with a connector for receiving a row of television modules, characterized in that, with the above-mentioned connectors being referred to as first connectors, and with each television module realising one of the functions among at least the functions of selective filtering, amplification and frequency conversion for UHF signals received either from an antenna or from another module, each of the two parallel faces of each module is provided with a second connector for a television signal, which connector is arranged in such a way that, like the first, it enables two modules of a row to be interconnected, a selective filtering module has, within the module, a UHF input line of 75 ohms interconnecting the two first connectors and a UHF output line of 75 ohms interconnecting the two second connectors with selective coupling between these two lines, while in a module for amplification or for frequency conversion the first connector on the face intended to face the principal module constitutes a UHF output signal and the first connector on the face intended not to face the principal module constitutes a UHF input signal which is charged by a charge contained in the module, the signal to be converted in frequency or to be amplified being supplied either *via* the second connector on the face intended not to face the principal module, or *via* a third connector which is arranged on a third face of the module, in which case the two second connectors are interconnected by a 75-ohm line, and the principal module comprises coaxial input connectors for the VHF antenna and four coaxial connectors, *viz*. two "first" and two "second" connectors arranged to permit the connection of two rows each constituted by UHF modules, and means for amplifying and adding together the signals at the second connectors and the signal at the input connectors for the VHF antenna, and for supplying them at an output.

2. A system as claimed in Claim 1, characterized in that each 75 Ω-line ensures the passage of a DC component which is superimposed on the UHF signal for the supply of said amplification and/or frequency conversion modules from a supply circuit arranged in said principal module.

3. A system as claimed in Claim 1 or 2, also comprising, an amplifier module for the satellite band, characterized in that this satellite module and the principal module have interconnection and coupling means for supplying the whole of signals from the satellite and from said principal module on at least one wideband output connection.

4. A system as claimed in Claim 3, characterized in that said satellite module has also wideband divider means for supplying the whole of said signals to a plurality of output connections.

5. A system as claimed in Claim 3 or 4, in which said satellite module and said principal module are separately assembled in moulded housings, characterized in that the same exterior housing model is used for each of the two modules, which housing comprises at least.:
- on a first face, 3 connectors for connecting, dependent on the type of module, either the VHF inputs or the wideband outputs,
- on a second face, 2 connectors, one male and one female, for directly interconnecting the two modules,
- on a third face, a connector for receiving the satellite signals,
- on a fourth face, four connectors for connecting the two rows of UHF modules.

6. A system as claimed in any one of the preceding Claims, characterized in that the system is assembled on a supporting panel having guide rails and in that each module comprises a system of lugs arranged to glide along said rails and to be held thereby, the modules thus being guided in such a way that the coaxial connectors to be interconnected are correctly situated opposite each other.

## Patentansprüche

1. Verstärkungssystem für die Signalverteilung in Gemeinschaftsantennenanlagen, das baukastenartig aus Fernsehmodulen zusammengesetzt ist, die ihrerseits auf einem Grundmodul mit einer Stromversorgung aufgebaut sind, wobei jedes der Fernsehmodule mindestens eine erste Seite besitzt, die mit einem Fernsehsignalstecker ausgerüstet ist, sowie eine zur ersten planparallele zweite Seite, die ebenfalls mit einem Fernsehsignalstecker ausgerüstet ist, wobei diese Stecker so angeordnet sind, daß sich die Fernsehmodule direkt zusammenstecken lassen, um so eine Reihe zu bilden, und wobei das Grundmodul mit einem Stecker ausgerüstet ist, um eine Reihe solcher Fernsehmodule aufzunehmen, dadurch gekennzeichnet, daß die genannten Stecker als erste Stecker bezeichnet werden, wobei jedes der Fernsehmodule für die über eine Antenne oder eine andere Vorrichtung empfangenen UHF-Signale eine aus den mindestens folgenden Funktionen realisiert: selektive Filterung, Verstärkung oder Frequenzumsetzung, wobei jedes Fernsehmodul auf jeder der beiden planparallelen Seiten einen sog. ersten Stecker und einen sog. zweiten Stecker für Fernsehsignale besitzt, die so angeordnet sind, daß die Module zu einer Reihe zusammengesteckt werden können, und daß ein selektives Filtermodul im Innern eines Moduls einerseits eine UHF-Eingangsleitung mit 75 Ohm besitzt, die die beiden ersten Stecker untereinander verbindet, und andererseits eine UHF-Ausgangsleitung mit 75 Ohm besitzt, die die beiden zweiten Stecker untereinander verbindet, mit selektiver Kopplung zwischen diesen beiden Leitungen, und daß in einem Verstärkungs- oder Frequenzumsetzungsmodul der erste Stecker, der sich auf der dem Grundmodul zugewandten Seite befindet, einen UHF-Signalausgang darstellt, und daß der erste Stecker, der sich auf der dem Grundmodul abgewandten Seite befindet, einen UHF-Signaleingang darstellt, der seinerseits durch eine im Modul befindliche Last belastet wird, und daß das zu verstärkende oder in der Frequenz umzusetzende Signal entweder über den zweiten, auf der dem Grundmodul abgewandten Seite befindlichen Stecker, oder über einen dritten, auf einer dritten Seiten des Moduls befindlichen Stecker eingespeist wird, wobei im letzteren Fall die beiden zweiten Stecker mit einer 75-Ohm-Leitung untereinander verbunden sind, und daß das Grundmodul einerseits koaxiale VHF-Antenneneingangsstecker und andererseits vier koaxiale Stecker enthalt, die als zwei "erste" und zwei "zweite" Stecker bezeichnet werden und die so angeordnet sind, daß an sie zwei Reihen aus UHF-Modulen angeschlossen werden können, sowie weiterhin Mittel enthält, um die an den zweiten Steckern anliegenden Signale und das an den VHF-Antenneneingangssteckern anliegende Signal zu verstärken, zusammenzumischen und über einen Ausgang auszugeben.

2. System nach Anspruch 1, dadurch gekennzeichnet, daß jeder der 75-Ohm-Leitungen darüberhinaus einen den UHF-Signalen überlagerten Gleichspannungsanteil hindurchläßt, um die Verstärker- und/oder Frequenzumsetzungsmodule ausgehend von einer Stromversorgungsschaltung im Grundmodul mit Strom zu versorgen.

3. System nach einem der Ansprüche 1 oder 2, das ein Verstärkermodul für das Satellitenband enthält, dadurch gekennzeichnet, daß dieses Satellitenmodul und das Grundmodul Mittel enthalten, um diese beiden Module miteinander zu verbinden und zu koppeln, so daß auf mindestens einem gemeinsamen Breitband-Ausgang die Gesamtheit der einerseits vom Satelliten, andererseits vom Grundmodul gelieferten Signale ausgegeben werden kann.

4. System nach Anspruch 3, dadurch gekennzeichnet, daß das Satellitenmodul darüberhinaus Mittel zur Breitband-Signalverteilung enthält, so daß die Gesamtheit der Signale über mehrere Ausgänge ausgegeben werden kann.

5. System nach einem der Ansprüche 3 oder 4, wobei das Satellitenmodul und das Grundmodul getrennt in gegossene Gehäuse eingebaut werden und dadurch gekennzeichnet, daß für jedes der beiden Module dasselbe äußere Gehäusemodell verwendet wird, wobei dieses Gehäuse mindestens die folgenden Teile aufweist:
- drei Stecker auf einer ersten Seite, an denen, je nach Modultyp, die VHF-Eingänge oder die Breitband-Ausgänge angeschlossen werden;
- zwei Stecker auf der zweiten Seite, einmal als Stecker mit Buchse und einmal als Stecker mit Stift ausgeführt, um die beiden Module direkt zusammenstecken zu können;
- einen Stecker auf einer dritten Seite, über den die Satellitensignale eingespeist werden;
- vier Stecker auf der vierten Seite, an die die beiden Reihen mit UHF-Modulen angeschlossen werden.

6. System nach einem der vorgenannten Ansprüche, dadurch gekennzeichnet, daß es auf einer mit Führungsschienen versehenen Montageplatte aufgebaut ist, und dadurch gekennzeichnet, daß jedes Modul mit Befestigungslaschen ausgerüstet ist, so daß sie nebeneinander auf die Schienen aufgesetzt und dort gehalten werden und wobei die Module dergestalt geführt werden, daß die Koaxialstecker richtig zueinander liegen.
